# EUROPÄISCHE PATENTSCHRIFT

(11) **EP 0 305 681 B1**
(45) Veröffentlichungstag und Bekanntmachung des Hinweises auf die Patenterteilung: **23.06.1993**
(21) Anmeldenummer: 88110815.3
(22) Anmeldetag: 07.07.1988
(51) Int. Cl.: H05K 7/14

(54) **Schwenkbarer Handhabungsgriff**
Rotatable hand lever
Manette basculante

(30) Priorität: 01.09.1987 CH 3345/87
(43) Veröffentlichungstag der Anmeldung: 08.03.1989
(73) Patentinhaber: ELMA ELECTRONIC AG, CH-8620 Wetzikon (CH)
(72) Erfinder: Schindler, Walter A., CH-8121 Englen (CH)
(74) Vertreter: Hammer, Bruno, Dr.

(56) Entgegenhaltungen:
- EP-A- 0 097 228
- EP-A- 0 191 968
- US-A- 4 233 646

## Beschreibung

Die Erfindung betrifft eine Anordnung mit einem schwenkbaren Handhabungsgriff für das Ausdrücken und Einstecken von vielpoligen Steckverbindern einer in Führungshalter eines Baugruppenträgers eingeschobenen Steckplatte, wobei beim Schwenken des durch eine Oeffnung in der Frontplatte der Steckplatte reichenden Griffes eine Nase an einem Ende des Schwenkbereiches nach Anliegen an einer Ausdrück-Fläche die Verbindung zwischen Steckverbindern an der Steckplatte und den Federleisten in dem Baugruppenträger aufhebt.

Eine solche Anordnung ist bekannt aus der EP-A-191 968. Diese bekannte Konstruktion hat den Nachteil, dass mit ihr wohl die Steckverbinder aus den Federleisten gelöst werden können, dass jedoch ein Herstellen der Steckverbindung nicht möglich ist.

Aufgabe der Erfindung ist es daher, die bekannte Konstruktion so zu verbessern, dass auch ein Zusammenfügen von Steckverbindern und Federleisten mit dem Handhabungsgriff ermöglicht wird.

Diese Aufgabe wird dadurch gelöst, dass am Ende des Schwenkbereichs in Gegenrichtung an dem Handhabungsgriff ein zweiter nasenförmiger Ansatz vorgesehen ist, der im Zusammenwirken mit einem über der Ausdrück-Fläche und in Gegenrichtung dazu angeordneten Anschlag im Baugruppenträger die Steckverbindungen herstellt.

Nach Anliegen am Anschlag des Längsprofils übt der nasenförmige Ansatz auf die schwenkbar mit ihm bzw. dem Griff verbundene Steckplatte eine horizontale Kraft aus, die im wesentlichen senkrecht von der Frontplatte in den Baugruppenträger hinein gerichtet ist; die in den Führungshaltern geführten Steckplatten werden dadurch nach hinten verschoben, wobei die Steckverbindung zwischen Steckverbindern an der Steckplatte und Federleisten im Baugruppenträger hergestellt wird.

Konstruktiv vorteilhaft ist es, wenn Ausdrück-Fläche und Einsteckanschlag in einem Längsprofil des Baugruppenträgers vereinigt sind, das mehreren Steckplatten gemeinsam ist.

Weiterhin ist es wünschenswert, den Weg der durch den Handhabungsgriff hervorgerufenen horizontalen Bewegung in Einsteckrichtung zu begrenzen; es kann daher die Massnahme getroffen sein, dass der Schwenkbereich des Griffes in Einsteckrichtung durch eine Ausnehmung begrenzt ist, in die die Frontplatte eingreift.

Im folgenden wird die Erfindung anhand eines Ausführungsbeispiels im Zusammenhang mit der Zeichnung näher erläutert.
- Fig. 1: zeigt schematisch in einem Schnitt durch einen nicht weiter dargestellten Baugruppenträger eine Steckplatte, deren Steckverbinder in Federleisten des Baugruppenträgers eingesteckt sind;
- Fig. 2a - 2c: gibt als Detail aus Fig. 1 in vergössertem Massstab einen Schnitt durch die Frontplatte der Steckplatte mit dem neuen Handhabungsgriff wieder, wobei der Griff in

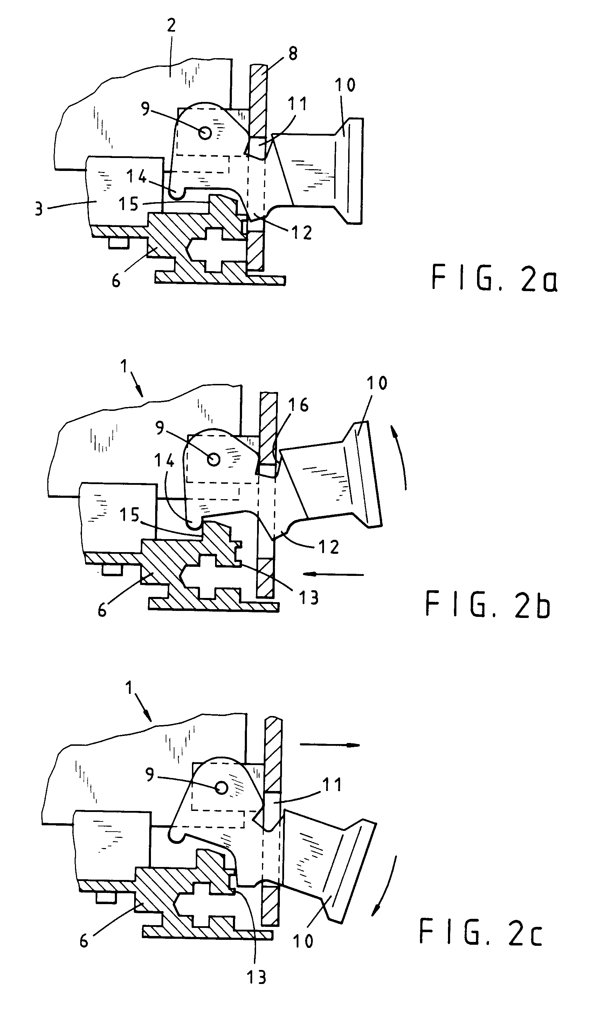

- Fig. 2a: in neutraler Stellung, in
- Fig. 2b: in Einsteckstellung und in
- Fig. 2c: in Ausdrückstellung dargestellt ist.

Die Steckplatte 1 besteht aus einer Leiterplatte 2, die in im Baugruppenträger montierten Führungshalter 3 eingeschoben sind; an ihren linken Enden sind Steckverbinder 4 auf der Platte 2 befestigt, die in Federleisten 5 eingesteckt sind. Diese sind - ebenso wie die Führungshalter 3 und Längsprofile 6 - in einem nicht weiter gezeigten Baugruppenträger montiert.

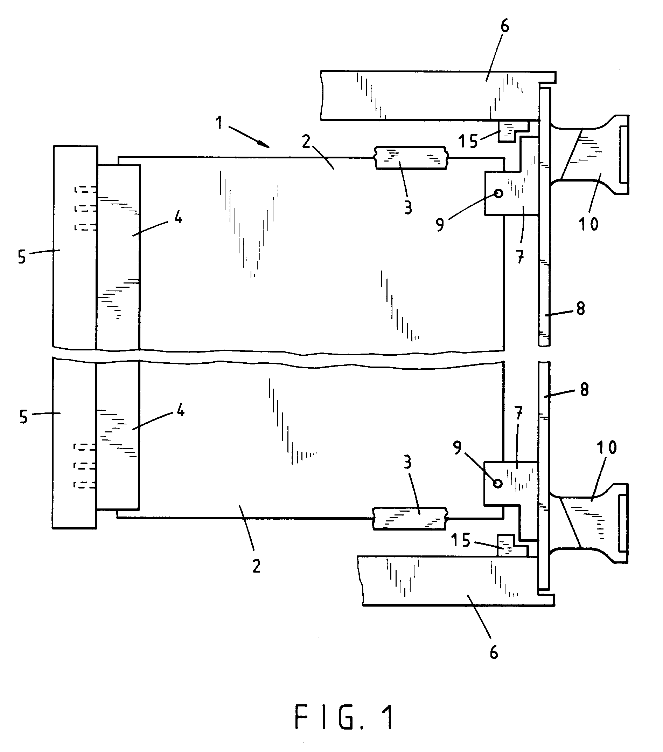

An der Vorderseite (rechts in Fig. 1) ist die Leiterplatte 2 oben und unten über Halteknoten 7 an einer mit den Längsprofilen 6 verbundenen Frontplatte 8 mit nicht gezeigten Schrauben befestigt. Auf der durch die Halteknoten 7 und die Leiterplatte 2 verlaufenden Befestigungsachse 9 sitzt - relativ zur Leiterplatte 2 schwenkbar - ein Handhabungsgriff 10.

Wie Fig. 2 zeigt, erstreckt sich der Handhabungsgriff 10 durch eine schlitzartige Aussparung 11 der Frontplatte 8. Er weist an seiner Unterseite, von der Achse 9 aus zur Frontplatte 8 hin gesehen, eine Nase 12 auf, die beim Abwärtsschwenken des Griffes 10 gegen eine Ausdrückfläche 13 drückt und dadurch die Steckplatte 1 relativ zum Längsprofil 6 bzw. zum Baugruppenträger - in Fig. 2c dargestellt und durch Pfeile verdeutlicht - nach rechts verschiebt, wodurch die Steckverbindung zwischen den Steckverbindern 4 und den Federleisten 5 gelöst wird.

Relativ zur Befestigungsachse 9 auf der anderen Seite, jedoch in radial kürzerem Abstand davon, hat der Handhabungsgriff 10 erfindungsgemäss einen nasenförmigen Ansatz 14. Dieser wirkt zusammen mit einem Einsteckanschlag 15, der entweder auf dem Profil 6 befestigt ist (Fig. 1 unten), oder mit diesem Profil aus einem Stück besteht (Fig. 1 oben und Fig. 2).

Nach dem Anliegen an diesem Anschlag 15 - bei einer Schwenkbewegung in Fig. 2 nach oben - wird die Steckplatte relativ zum Längsprofil 6 nach links verschoben (Fig. 2b), wodurch eine Steckverbindung zwischen den Elementen 4 und 5 hergestellt wird.

Eine Ausnehmung 16 am Handhabungsgriff 10 bewirkt, dass im eingerasteten Zustand der Schlitz 11 in der Frontplatte 8 nicht sichtbar ist.

Die Begrenzung der Bewegung der Steckerplatte 1 in Einsteckrichtung wird durch das Aufliegen der Frontplatte 8 am Profil 6 bzw. das Aufliegen des Steckverbinders 4 auf der Federleiste 5 erreicht.

## Patentansprüche

1. Anordnung mit einem Schwenkbaren Handhabungsgriff (10) für das Ausdrücken und Einstecken von vielpoligen Steckverbindern (4) einer in Führungshalter (3) eines Baugruppenträgers eingeschobenen Steckplatte (1), wobei beim Schwenken des durch eine Öffnung in der Frontplatte (8) der Steckplatte (1) reichenden Griffes (10) eine Nase (12) an einem Ende des Schwenkbereiches nach Anliegen an einer Ausdrück-Fläche (13) die Verbindung zwischen Steckverbindern (4) an der Steckplatte (1) und den Federleisten (5) in dem Baugruppenträger aufhebt, dadurch gekennzeichnet, dass
am Ende des Schwenkbereiches in Gegenrichtung an dem Handhabungsgriff (10) ein zweiter nasenförmiger Ansatz (14) vorgesehen ist, der im Zusammenwirken mit einem über der Ausdrück-Fläche (13) und in Gegenrichtung dazu angeordneten Anschlag (15) im Baugruppenträger die Steckverbindungen herstellt.

2. Anordnung nach Anspruch 1, dadurch gekennzeichnet, dass Ausdrück-Fläche (13) und Einsteckanschlag (15) in einem Längsprofil (6) des Baugruppenträgers vereinigt sind, das mehreren Steckplatten (1) gemeinsam ist.

3. Anordnung nach Anspruch 1, dadurch gekennzeichnet, dass im Schwenkbereich des Griffes (10) in Einsteckrichtung eine Ausnehmung (16) vorhanden ist, die die Oeffnung (11) in der Frontplatte (8) im eingeschobenen Zustand abdeckt.

## Claims

1. An arrangement having a swivelling hand lever (10) for the ejection and insertion of multi-pole connectors (4) of a printed card (1) inserted into holders (3) of a sub-rack, in the course of which, when the hand lever (10) extending through an aperture in the front plate (8) of the printed card (1) is swivelled, a tappet (12) at one end of the swivelling region, after abutting an ejection surface (13), removes the connection between connectors (4) at the printed card (1) and the female multi-point connectors (5) in the sub-rack,
**characterised in that** at the end of the swivelling region in the opposite direction on the hand lever (10) is provided a second tappet (14), which in cooperation with a stop (15) in the sub-rack disposed above the ejection surface (13) and in the opposite direction thereto produces the plug-in connections.

2. An arrangement according to Claim 1,
**characterised in that** the ejection surface (13) and insertion stop (15) are united in a longitudinal section (6) of the sub-rack, which is shared by several printed cards (1).

3. An arrangement according to Claim 1,
**characterised in that** in the swivel region of the hand lever (10) in the insertion direction is provided a recess (16), which covers the aperture (11) in the front plate (8) in the inserted state.

## Revendications

1. Structure comprenant un bouton de manipulation (10) pouvant subir des mouvements de basculement et destiné à l'éjection et à l'enfichage de cavaliers multipolaires (4) d'une plaque embrochable (1) enfilée dans des appuis de guidage (3) faisant partie d'un support de module, un talon (12) situé à une extrémité de la plage de pivotement du bouton (10) supprimant la liaison entre les cavaliers (4) de la plaque embrochable (1) et les connecteurs multipolaires (5) à ressorts du support de module après qu'il s'est appliqué contre une surface d'éjection (13) lors du basculement du bouton (10) qui passe dans un trou de la plaque antérieure (8) de la plaque embrochable (1), caractérisée en ce qu'une seconde protubérance (14) en forme de talon prévue en sens inverse sur le bouton (10) de manipulation à l'extrémité de la plage de pivotement établit les liaisons par enfichage en coopérant avec une butée (15) du support de module qui est disposée au-dessus de la surface d'éjection (15) et orientée en sens inverse par rapport à celle-ci.

2. Structure selon la revendication 1, caractérisée en ce que la surface d'éjection (13) et la butée d'enfichage (15) sont réunies dans un profilé longitudinal (6) du support de module qui est commun à plusieurs plaques embrochables.

3. Structure selon la revendication 1, caractérisée en ce qu'une échancrure (16) orientée dans le sens de l'enfichage et se trouvant dans la plage de pivotement du bouton (10) recouvre le trou (11) de la plaque antérieure (8) à l'état d'emboîtement.
